# EUROPÄISCHE PATENTSCHRIFT

(11) **EP 0 519 090 B1**
(45) Veröffentlichungstag und Bekanntmachung des Hinweises auf die Patenterteilung: **15.02.1995**
(21) Anmeldenummer: 91109721.0
(22) Anmeldetag: 13.06.1991
(51) Int. Cl.: H03K 17/945, G01S 7/52

(54) **Ultraschall-Näherungsschalter mit Synchronisiereinrichtung**
Ultrasonic proximity switch with synchronization equipment
Commutateur de proximité ultrasonore avec équipement de synchronisation

(43) Veröffentlichungstag der Anmeldung: 23.12.1992
(73) Patentinhaber: SIEMENS AKTIENGESELLSCHAFT, 80333 München (DE)
(72) Erfinder: Luber, Ernst, W-8459 Neunkirchen (DE)

(56) Entgegenhaltungen:
- HONEYWELL GERäTE-INFORMATION E-108 DB-1067.2,'Serie 945 Ultraschall-Abstandssensoren'
- NTIS TECH NOTES. April 1988, SPRINGFIELD, VA US Seite 259; 'Ultrasonic ranging system with increased resolution'
- IEEE TRANSACTIONS ON CONSUMER ELECTRONICS. Bd. CE-25, Nr. 4, August 1979, NEW YORK US Seiten 440-445; OZAWA ET AL.: 'New portable video cassette recorder'

## Beschreibung

Die Erfindung betrifft Ultraschall-Näherungsschalter mit einem Freigabeausgang, der über eine gemeinsame Leitung mit dem Freigabeausgang von mindestens einem weiteren Ultraschall-Näherungsschalter verbindbar ist, mit einem Steuerbaustein, der einen Ein- und einen Ausgang aufweist.

Beim Betrieb von benachbarten Ultraschall-Näherungsschaltern kann es aufgrund von ungünstigen Reflektionen des Ultraschalls im Umfeld der Näherungsschalter zur gegenseitigen Beeinflussung kommen. Die Laufzeitmessung eines Ultraschall-Näherungsschalters wird vom Echosignal des benachbarten Ultraschall-Näherungsschalters gestört, wenn die Ultraschall-Näherungsschalter nicht synchron senden. Es können dann möglicherweise die Echosignale nicht den Ultraschall-Näherungsschaltern richtig zugeordnet werden, die die entsprechenden Sendeimpulse ausgegeben haben. Daher kommt es bei der Laufzeitauswertung zu Fehlern, indem der Schaltausgang undefiniert gesetzt wird. Zur Lösung des Problems war es bisher bekannt, die Ultraschall-Näherungsschalter seriell zu betreiben, indem die Versorgungsspannungen der Ultraschall-Näherungsschalter zyklisch zu- bzw. abgeschaltet wurden. Die Ansprechzeit der Ultraschall-Näherungsschalter ist bei dieser Technik entsprechend lang und wird sogar noch durch interne Reset-Zeiten verzögert. Eine weitere Möglichkeit, die gegenseitige Beeinflussung zu vermeiden, bestand bisher in der Einhaltung von Einbauvorschriften, d.h. der Vorgabe von Mindestabständen für die Installierung der Ultraschall-Näherungsschalter. Die Mindestabstände sind jedoch sehr applikationsabhängig. Für viele Einsatzmöglichkeiten scheidet diese Methode aus, wenn ein hohes Sicherheitsmaß gefordert ist. Eine weitere Lösung zur Vermeidung der gegenseitigen Beeinflussung besteht darin, daß die benachbart betriebenen Näherungsschalter über ihren Freigabeausgang miteinander durch eine gemeinsame Leitung verbunden werden und hierüber eine Parallel-Synchronisation erfolgt. Hierbei werden von allen Näherungsschaltern zum gleichen Zeitpunkt Sendeimpulse abgegeben, so daß das Problem der zeitlich richtigen Zuordnung der Echosignale zu den betreffenden Ultraschall-Näherungsschaltern entfällt. Eine derartige Parallel-Synchronisation ist z.B. aus der Firmenschrift (Honeywell MICRD SWITCH Geräte Information E 108/DB-1067.2) bekannt. Die Nachteile des hier beschriebenen Näherungsschalters bestehen darin, daß die Laufzeitauswertung des Geräts keine gegliederten Auswertealgorithmen besitzt und das Gerät daher störungsempfindlich ist. Dieser Näherungsschalter ist kein genormtes Gerät und bietet nicht die Möglichkeit der seriellen Synchronisation.

Der Erfindung liegt die Aufgabe zugrunde, Ultraschall-Näherungsschalter zu schaffen, nach deren Zusammenschaltung über ihre Freigabeausgänge durch eine gemeinsame Leitung eine selbsttätige Synchronisation parallel oder seriell möglich ist. Dies wird erreicht beim Gegenstand gemäß Anspruch 1. Der Vorteil besteht weiterhin darin, daß bei diesem Aufbau verschiedene Gerätetypen sich selbsttätig synchronisieren lassen, d.h. zusätzlicher Aufwand für z.B. besondere Einstellungen nicht erforderlich ist. Weiterhin erweist es sich als vorteilhaft, daß die Ultraschall-Näherungsschalter Kompaktnäherungsschalter sein können, die nur einen Vierpolstecker-Anschluß gemäß der Norm VDEO660 Teil 208 aufweisen. Weitere vorteilhafte Ausgestaltungen der Erfindung sind in den Ansprüchen 2 bis 6 angegeben. Hierzu gehört der Betrieb von Näherungsschaltern gemäß Anspruch 4 und 5, die benachbart sind und über die gemeinsame Leitung mit Parallelsynchronisation und serieller Synchronisation betrieben werden. Außerdem erweist es sich als zweckmäßig, wenn über eine an die gemeinsame Leitung anschließbare externe Steuerung der Synchronisationsbetrieb steuerbar ist.

In der Zeichnung ist ein Ausführungsbeispiel der Erfindung dargestellt, das im folgenden näher beschrieben ist.

Es zeigen:
- FIG 1: einen Meßzyklus eines Ultraschall-Näherungsschalters
- FIG 2: ein Synchronisierimpulsraster zum Betrieb benachbarter Ultraschall-Näherungsschalter,
- FIG 3: zwei über ihren Freigabeausgang durch eine gemeinsame Leitung verbundene Näherungsschalter,
- FIG 4: ein Impulsdiagramm zur Prioritätenfestlegung bei serieller Synchronisation.

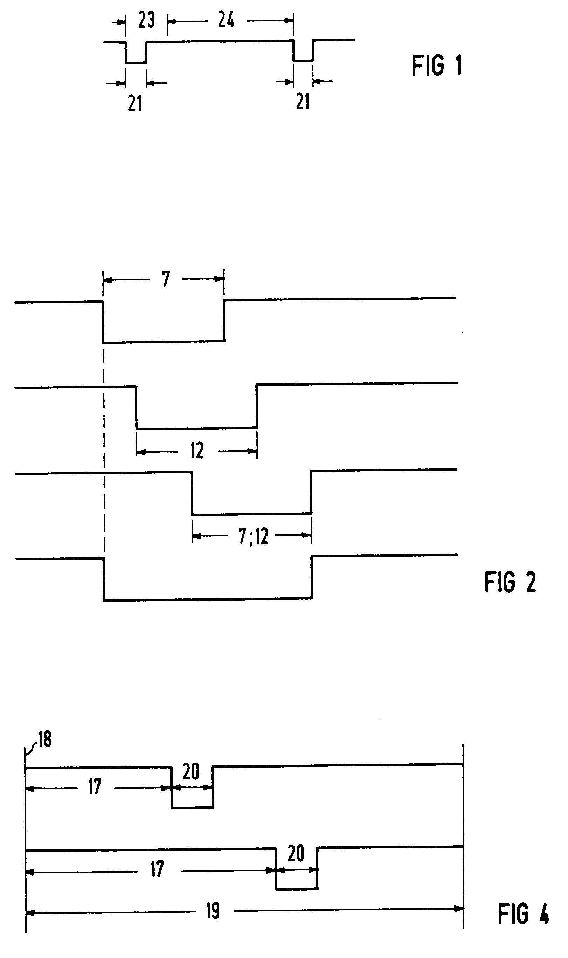

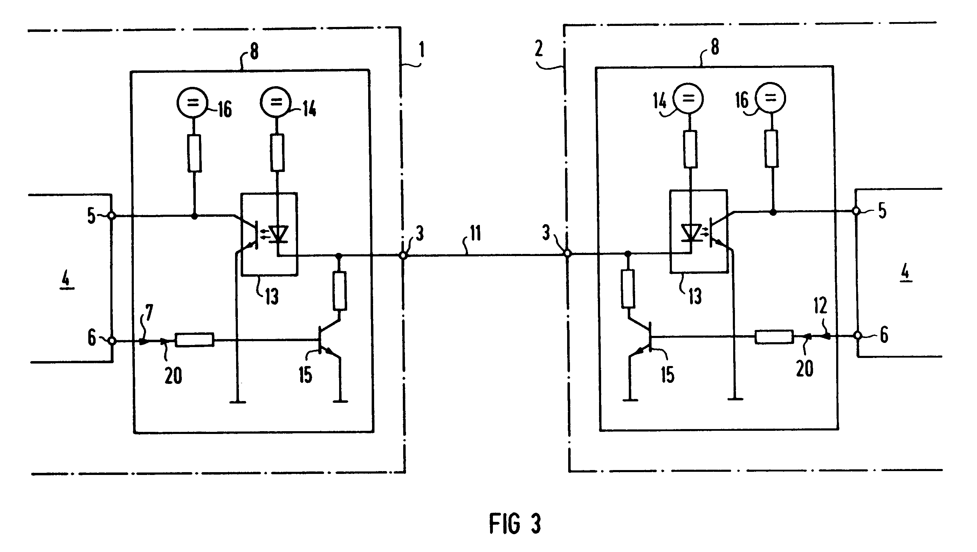

In Figur 1 ist ein Meßzyklus eines Näherungsschalters dargestellt, der mit der Ausgabe eines Sendeimpulses 21 von etwa 150 »s Dauer beginnt und der einen Erfassungsbereich 23 von z.B. 4,7 ms umfaßt, dem sich eine Auswertedauer 24 anschließt. Diese Auswertedauer 24 ist abhängig vom Gerätetyp unterschiedlich lang und schwankt in einem Bereich von z.B. 10 bis 14 ms. Dieser Schwankungsbereich hat zur Folge, daß selbst nach einer Paralellsynchronisation, d.h. nach dem gemeinsamen Absenden der Sendeimpulse von benachbarten Ultraschall-Näherungsschaltern der Meßzyklus für alle nicht zur gleichen Zeit beendet ist und somit erst abgewartet werden muß, bis jeder Ultraschall-Näherungsschalter zum Start eines neuen Meßzyklusses bereit ist. Hierzu erzeugt jeder Ultraschall-Näherungsschalter nach Beendigung der Auswertedauer 24 einen eigenen Synchronisierimpuls 7, wobei die Länge der Synchronisierimpulse 7 so gewählt ist, daß auf jeden Fall mindestens zwei Synchronisierimpulse 7 bzw. 12 sich zeitlich teilweise überlappen. In FIG 2 ist beispielhaft ein entsprechendes Raster mit Synchronisierimpulsen 7 bzw. 12 von drei Näherungsschaltern dargestellt. Der Synchronisierimpuls 7 bzw. 12 wird in dem durch einen Mikroprozessor realisierten Steuerbaustein 4 der Ultraschall-Näherungsschalters 1,2 erzeugt (siehe FIG 3). Benachbart betriebene Ultraschall-Näherungsschalter 1 und 2 sind über ihren Freigabeausgang 3 durch eine gemeinsame Leitung 11 miteinander verbunden. Zwischen dem Mikroprozessor 4 und dem Freigabeausgang 3 liegt eine Schaltung 8. Der Mikroprozessor 4 gibt an seinem Ausgang 6 den Synchronisierimpuls 7 an die Schaltung 8 ab, die daraufhin einen Potentialwechsel der gemeinsamen Leitung 11 hervorruft, was zugleich eine entsprechende Rückmeldung an einem Eingang 5 des Mikroprozessors 4 im Ultraschall-Näherungsschalter bewirkt. Dies bedeutet, daß der Potentialzustand auf der gemeinsamen Leitung 11 solange erhalten bleibt, wie zumindest noch ein Synchronisierimpuls 7 bzw. 12 ansteht, was in FIG 2 durch das unten dargestellte, aus allen Synchronisierimpulsen 7 bzw. 12 folgende Gesamtsignal ausgedrückt ist. Durch die erwähnte Rückmeldung des Potentialzustands der gemeinsamen Leitung 11 an den Eingang 5 vom Mikroprozessor 4 jedes Ultraschall-Näherungsschalters wird somit die Information geliefert, daß noch nicht sämtliche Ultraschall-Näherungsschalter an der gemeinsamen Leitung 11 zum Betrieb bereit sind. Erst nach Ablauf des letzten Synchronisierimpulses 7 bzw. 12 im Synchronisierimpulsraster geht die gemeinsame Leitung 11 auf einen anderen Potentialzustand über und zeigt daraufhin dem Eingang 5 des Mikroprozessors 4 an, daß für alle Ultraschall-Näherungsschalter Sendebereitschaft besteht. Dieser letzte Potentialwechsel wird zur Einleitung der Sendeimpulse 21 bei Parallelsynchronisation verwendet. In FIG 3 sind zwei Ultraschall-Näherungsschalter 1 und 2 dargestellt, die über Ihren Freigabeausgang 3 durch eine gemeinsame Leitung 11 miteinander verbunden sind. In jedem Ultraschall-Näherungsschalter befindet sich ein Mikroprozessor 4 mit einem Eingang 5 und einem Ausgang 6. Zwischen diesen Anschlüssen und dem Freigabeausgang 3 liegt die Schaltung 8 mit folgendem Aufbau. Zwischen dem Freigabeausgang 3 und dem Massepotential ist ein Transistor 15 geschaltet, der über den Ausgang 6 des Mikroprozessors 4 ansteuerbar ist und durch eine erste Spannungsquelle 14 über einen Optokoppler 13 gespeist wird. Die Schaltstrecke des Optokopplers 13 liegt einerseits am Eingang 5 des Mikroprozessors 4 und über einen Widerstand an einer zweiten Spannungsquelle 16 sowie andererseits an Massepotential. Durch Anlegen eines im Mikroprozessor 4 erzeugten Synchronisierimpulses 7 am Ausgang 6 wird der Transistor 15 durchgeschaltet und damit die am Freigabeausgang 3 liegende Leitung 11 auf Massepotential gelegt. Mit dem Durchschalten des Transistors 15 wird zugleich der Optokoppler 13 durchgeschaltet und dadurch ebenfalls der Eingang 5 des Mikroprozessors 4 auf Massepotential gelegt. Die Synchronisierimpulse 7 der miteinander verbundenen Ultraschall-Näherungsschalter überlappen sich zeitlich mindestens teilweise, so daß an den Eingängen 5 der Mikroprozessoren 4 aller miteinander verbundenen Ultraschall Näherungsschalter solange Massepotential ansteht, wie dies auch für die gemeinsame Leitung 11 zutrifft, d. h. solange noch irgendein Synchronisierimpuls 7 bzw. 12 ansteht. Die Dauer ist in FIG 2 durch den unteren Gesamtimpuls wiedergegeben. Erst nachdem der zeitlich zuletzt auftretende Synchronisierimpuls 7 bzw. 12 abgelaufen ist, wird die gemeinsame Leitung 11 auf ein durch die erste Spannungsquelle 14 bereitgestelltes High-Potential gelegt und damit zugleich auch ein High-Potential an jedem Eingang 5 von den Mikroprozessoren 4 bewirkt, das der zweiten Spannungsquelle 16 entspricht. Durch diesen letzen Potentialwechsel am Eingang 5 ist die Information gegeben, daß sämtliche Ultraschall-Näherungsschalter zum Senden bereit sind und daß nun der Sendeimpuls 21 (siehe FIG 1) zum gleichen Zeitpunkt abgegeben werden kann.

Stellt sich das Problem, daß unterschiedlich beabstandete Gegenstände mit benachbarten Ultraschall-Näherungsschaltern erfaßt werden sollen, so ist hierfür der Betrieb mit serieller Synchronisation vorzunehmen. Der Meßzyklus eines Näherungsschalters wird hierbei durch einen weiteren Meßzyklus eines anderen benachbarten Ultraschall-Näherungsschalters abgelöst, so daß jeweils immer nur mit einem einzigen Ultraschall Näherungsschalter eine Messung vorgenommen wird. Dabei werden Ultraschall-Näherungsschalter mit dem für Parallelsynchronisation beschriebenen Aufbau verwendet. Auch bei der seriellen Synchronisation muß zunächst festgestellt werden, ob sämtliche an einer gemeinsamen Leitung angeschlossenen Ultraschall-Näherungsschalter zum Betrieb bereit sind. Hierzu läuft, wie bei der Parallelsynchronisation, zunächst ein Synchronisierimpulsraster nach FIG 2 ab, wobei nun jedoch der Zustandswechsel am Ende des unteren Gesamtimpulses auf das High-Potential sowohl der gemeinsamen Leitung 11 als auch am Eingang 5 der Mikroprozessoren 4 als Startpunkt 18 benutzt wird (siehe FIG 4). Jeder Ultraschall-Näherungsschalter erhält eine Adresse in Form eines Zeitabschnittes 17, der im Mikroprozessor 4 gespeichert ist und sozusagen als Kennung des jeweiligen Ultraschall-Näherungsschalters dient. Ausgehend vom gemeinsamen Startpunkt 18 werden diese Zeitabschnitte 17 gemäß dem Impulsdiagramm nach Figur 4 gestartet. Am Ende jedes Zeitabschnittes 17, der für den jeweiligen Ultraschall-Näherungsschalter typisch ist wird ein kurzer Prioritätenimpuls 20 abgegeben. Dabei sind die Adressen, d.h. die Zeitabschnitte 17 und die Dauer der Prioritätenimpulse 20 derart gewählt, daß die Prioritätenimpulse 20 sich zeitlich nicht überlappen. Mit dem Startpunkt 18 beginnt ein genügend groß gewähltes Zeitfenster 19 zu laufen, in dem in jedem Falle die Prioritätenimpulse 20 von allen benachbarten Ultraschall-Näherungsschaltern liegen. Diese Prioritätenimpulse 20 werden ebenfalls wie die Synchronisierimpulse bei der Parallelsynchronisation, im Mikroprozessor 4 erzeugt und von seinem Ausgang 6 an die Schaltung 8 abgegeben und bewirken für die Dauer des Prioritätenimpulses 20 einen auf Masse führenden Potentialwechsel auf der gemeinsamen Leitung 11. Damit führen die Prioritätenimpulse 20 ebenso wie zuvor beschrieben die Synchronisierimpulse 7 zu einem Potentialwechsel am Eingang 5 des Mikroprozessors 4. Somit erhält jeder Mikroprozessor 4 über seinen Eingang 5 nicht nur die Information wann im betreffenden Ultraschall-Näherungsschalter ein Prioritätsimpuls 20 vorliegt, sondern auch über die gemeinsame Leitung 11 die Rückmeldung über die Prioritätsimpulse 20 von benachbarten Ultraschall-Näherungsschaltern. Auf diese Weise ist es möglich, daß jeder Ultraschall-Näherungsschalter sich durch seinen Mikroprozessor 4 merkt, an wievielter Stelle nach dem Startpunkt 18 sein Prioritätsimpuls 20 abgegeben wurde. Am Ende des Zeitfensters 19 durchläuft daraufhin der Näherungsschalter mit dem zuerst abgegebenen Prioritätsimpuls 20 einen Meßzyklus und gibt einen Sendeimpuls ab, während alle übrigen erst dann ihren Sendeimpuls nacheinander freigeben, wenn sie entsprechend der selbstermittelten Reihenfolge an der Reihe sind. Die auf diese Weise durchgeführte serielle Synchronisation hat den großen Vorteil von äußerst geringen Verzögerungszeiten, da der Betrieb der Ultraschall-Näherungsschalter nicht unterbrochen sondern nur die Aussendung der Sendeimpulse gesperrt wird und somit auch keine unnötigen Resetzeiten zum zusätzlichen Zeitverzug führen. Der beschriebene Schaltungsaufbau, der nicht nur für den Betrieb der Parallelsynchronisation sondern auch zur seriellen Synchronisation geeignet ist, ist insbesondere bei Kompaktgeräten von Vorteil, bei denen im allgemeinen auf eine externe Steuerung verzichtet wird und ein kostengünstiger Geräteaufbau angestrebt wird. Derartige Kompaktgeräte werden üblicherweise nur mit einem Vierpolsteckeranschluß ausgestattet, so daß für Synchronisationszwecke nur noch ein Ausgang zur Verfügung steht. Der beschriebene Aufbau läßt jedoch auch den Betrieb mit einer externen Steuerung zu, die an die gemeinsame Leitung 11 anschließbar ist, um über diese von außen her einen Betrieb mit spezieller Parallelsynchronisation oder serieller Synchronisation steuern können.

## Patentansprüche

1. Ultraschall-Näherungsschalter (1) mit einem Freigabeausgang (3), der über eine gemeinsame Leitung (11) mit dem Freigabeausgang (3) von mindestens einem zweiten Ultraschall-Näherungsschalter (2) verbindbar ist, mit einem Steuerbaustein (4), der einen Ein- (5) und einen Ausgang (6) aufweist, **dadurch gekennzeichnet,** daß durch den Steuerbaustein (4) an seinem Ausgang (6) ein erster Synchronisierimpuls (7) erzeugbar ist, der die Sendebereitschaft des Ultraschall-Näherungsschalters (4) signalisiert, daß zwischen dem Ein- (5) und Ausgang (6) sowie dem Freigabeausgang (3) eine Schaltung (8) vorgesehen ist, durch die der Freigabeausgang (3) solange in einen ersten Potentialzustand versetzbar ist, wie der erste Synchronisierimpuls (7) ansteht und daß die Schaltung (8) nach Beendigung des ersten Synchronisierimpulses (7) einen zweiten Potentialzustand am Freigabeausgang (3) bewirkt, wobei die Schaltung (8) der beiden Potentialzustände am Freigabeausgang (3) entsprechende Potentialzustände am Eingang (5) bewirkt und wobei selbst nach Beendigung des ersten Synchronisierimpulses (7) der erste Potentialzustand am Freigabeausgang (3) auch durch den weiteren, über die gemeinsame Leitung (11) verbindbaren, baugleichen Ultraschall-Näherungsschalter (2) herstellbar ist, wenn in diesem Ultraschall-Näherungsschalter (2) ein mit dem ersten Synchronisierimpuls (7) überlappender zweiter Synchronisierimpuls (12) erzeugbar ist, der noch ansteht, nachdem der erste Synchronisierimpuls (7) abgelaufen ist und der über den Freigabeausgang (3) des weiteren Ultraschall-Näherungsschalters (2) das Potential der gemeinsamen Leitung (11) bestimmt und somit den ersten Potentialzustand am Freigabeausgang (3) des ersten Ultraschall-Näherungsschalters (1) aufrechterhält, wodurch zugleich der Eingang (5) im Ultraschall-Näherungsschalter (1) in dem keinen Sendeimpuls freigebenden Zustand gehalten wird mit der Folge, daß eine Freigabe der Sendeimpulse in den miteinander über die gemeinsame Leitung (11) verbindbaren Ultraschall-Näherungsschaltern (1, 2) erst durchführbar ist, wenn beide Synchronisierimpulse (7, 12) abgelaufen sind und damit die gemeinsame Leitung (11) in den zweiten Potentialzustand überwechselt, was zugleich den am Eingang (5) zur Freigabe des Sendeimpulses erforderlichen Zustandswechsel bewirkt.

2. Ultraschall-Näherungsschalter nach Anspruch 1, **dadurch gekennzeichnet,** daß der Steuerbaustein als Mikroprozessor (4) ausgeführt ist.

3. Ultraschall-Näherungsschalter nach Anspruch 1 oder 2, **dadurch gekennzeichnet,** daß die Schaltung (8) derart ausgebildet ist, daß der Freigabeausgang (3) einerseits über einen Optokoppler (13) mit einer ersten Spannungsquelle (14) verbunden ist und andererseits zur Masse hin über einen Transistor (15) verbunden ist, der durch Synchronisierimpulse (7) ansteuerbar und durchschaltbar ist und durch den der Freigabeausgang (3) vom Potential der Versorgungsspannungsquelle (14) auf Massepotential wechselbar ist und daß bei Durchschaltung des Transistors 15 der Optokoppler (13) durchschaltet, wodurch der am Kollektor angeschlossene Eingang (5) auf das Potential der Masse am Emitteranschluß gelegt wird, und daß im Sperrzustand des Optokopplers (13) der Eingang (5) auf das Potential einer an ihm liegenden zweiten Spannungsquelle (16) liegt.

4. Verwendung von Ultraschall-Näherungsschaltern nach einem der vorhergehenden Ansprüche zum Betrieb mit Parallelsynchronisation, **dadurch gekennzeichnet,** daß die Näherungsschalter über ihren Freigabeausgang (3) durch eine gemeinsame Leitung (11) miteinander verbunden sind.

5. Verwendung von Ultraschall-Näherungsschaltern nach einem der vorangehenden Ansprüche 1, 2 oder 3 zum Betrieb mit serieller Synchronisation, **dadurch gekennzeichnet,** daß die Ultraschall-Näherungsschalter über ihren Freigabeausgang (3) durch eine gemeinsame Leitung (11) miteinander verbunden sind, daß die Ultraschall-Näherungsschalter jeweils in ihrem Steuerbaustein (4) eine sie kennzeichnende Adresse in Form eines Zeitabschnitts (17) gespeichert haben, daß durch den Ablauf der Synchronisierimpulse (7, 12) ein gemeinsamer Startpunkt (18) gesetzt wird für den gemeinsam beginnenden Ablauf der verschiedenen Zeitabschnitte (17) innerhalb eines vorgegebenen Zeitfensters (19) und daß nach Ablauf jedes Zeitabschnitts (17) jeder Steuerbaustein (4) einen Prioritätsimpuls (20) an seine angeschlossene Schaltung (8) abgibt, der von allen miteinander über die Leitung (11) verbundenen Näherungsschaltern empfangen wird, wobei die Reihenfolge der Prioritätenimpulse (20) in jedem Näherungsschalter erfaßt wird und am Ende des Zeitfensters (19) zunächst der Näherungsschalter seinen Sendeimpuls (21) abgibt und damit einen Meßzyklus startet, der den ersten Prioritätenimpuls (20) abgegeben hat und darauffolgend die übrigen Näherungsschalter nacheinander in der Reihenfolge der Prioritätenimpulse (20) ihren Meßzyklus durchlaufen.

6. Verwendung von Ultraschall-Näherungsschaltern gemäß Anspruch 4 oder 5, wobei die Synchronisation über eine mit der Leitung (11) verbundene, externe Steuerung erfolgt.

## Claims

1. Ultrasonic proximity switch (1) having an enabling output (3) which can be connected by way of a common line (11) to the enabling output (3) of at least a second ultrasonic proximity switch (2), having a control module (4) which has an input (5) and an output (6), characterized in that by means of the control module (4) at its output (6) a first synchronization pulse (7) can be generated which signals the transmission readiness of the ultrasonic proximity switch (4), in that between the input (5) and output (6) and the enabling output (3) a circuit (8) is provided, by means of which the enabling output (3) can be shifted into a first potential state for as long as the first synchronization pulse (7) is applied and in that the circuit (8) after the end of the first synchronization pulse (7) effects a second potential state at the enabling output (3), whereby the circuit (8) of the two potential states at the enabling output (3) effects corresponding potential states at the input (5) and whereby even after the end of the first synchronization pulse (7) the first potential state at the enabling output (3) can also be produced by the further similarly assembled ultrasonic proximity switch (2), which can be connected by way of the common line (11), if in this ultrasonic proximity switch (2) a second synchronization pulse (12) overlapping with the first synchronization pulse (7) can be generated, which synchronization pulse (12) is still present after the first synchronization pulse (7) has expired and which determines by way of the enabling output (3) of the further ultrasonic proximity switch (2) the potential of the common line (11) and thus maintains the first potential state at the enabling output (3) of the first ultrasonic proximity switch (1), whereby at the same time the input (5) in the ultrasonic proximity switch (1) is kept in the state which does not release any initial pulse, with the result that a release of the initial pulses in the ultrasonic proximity switches (1, 2) which can be connected to one another by way of the common line (11) can only be carried out if both synchronization pulses (7, 12) have expired and thus the common line (11) changes over into the second potential state, this at the same time effecting the state change necessary at the input (5) for the release of the initial pulse.

2. Ultrasonic proximity switch according to claim 1, characterized in that the control module is designed as a microprocessor (4).

3. Ultrasonic proximity switch according to claim 1 or 2, characterized in that the circuit (8) is constructed in such a way that the enabling output (3) is connected on one side by way of an optical coupler (13) to a first voltage source (14) and on the other side is connected towards earth by way of a transistor (15), which can be controlled and switched through by way of synchronization pulses (7) and by means of which the enabling output (3) can be changed from the potential of the supply voltage source (14) to earth potential and in that upon the switching-through of the transistor 15 the optical coupler (13) switches through, whereby the input (5) connected to the collector is applied to the potential of earth at the emitter terminal, and in that in the blocking state of the optical coupler (13) the input (5) is applied to the potential of a second voltage source (16) applied thereto.

4. Use of ultrasonic proximity switches according to one of the preceding claims for operation with parallel synchronization, characterized in that the proximity switches are connected to one another over their enabling output (3) by way of a common line (11).

5. Use of ultrasonic proximity switches according to one of the preceding claims 1, 2 or 3 for operation with serial synchronization, characterized in that the ultrasonic proximity switches are connected to one another over their enabling output (3) by way of a common line (11), in that the ultrasonic proximity switches have in each case stored in their control module (4) an address characterizing them in the form of a time segment (17), in that by way of the expiration of the synchronization pulses (7, 12) a common starting point (18) is set for the synchronously beginning course of the different time segments (17) within a specified time window (19) and in that after the expiration of each time segment (17) each control module (4) emits a priority pulse (20) to its connected circuit (8), which is received by all proximity switches connected to one another by way of the line (11), whereby the sequence of the priority pulses (20) in each proximity switch is detected and at the end of the time window (19) first of all the proximity switch emits its initial pulse (21) and thus starts a measuring cycle which has emitted the first priority pulse (20) and after this the remaining proximity switches pass through their measuring cycle successively in the sequence of the priority pulses (20).

6. Use of ultrasonic proximity switches according to claim 4 or 5, whereby the synchronization takes place by way of an external control connected to the line (11).

## Revendications

1. Interrupteur de proximité à ultrasons (1) comportant une sortie de libération (ou d'autorisation) (3), qui peut être reliée par l'intermédiaire d'une ligne commune (11) à la sortie de libération (3) au moins d'un second interrupteur de proximité à ultrasons (2), comportant un module de commande (4), qui possède une entrée (5) et une sortie (6), caractérisé par le fait que le module de commande (4) peut produire, au niveau de sa sortie (6), une première impulsion de synchronisation (7), qui signale l'état prêt à l'émission de l'interrupteur de proximité à ultrasons (4), qu'entre l'entrée (5) et la sortie (6) ainsi que la sortie de libération (3) est prévu un circuit (8), grâce auquel la sortie de libération (7) peut être placée dans un premier état de potentiel tant que la première impulsion de synchronisation (7) est présente, et qu'à la fin de la première impulsion de synchronisation (7), le circuit (8) fait apparaître un second état de potentiel sur la sortie de libération (3), le circuit (8) produisant à l'entrée (5), des états de potentiel qui correspondent aux deux états de potentiel présents sur la sortie de libération (3), tandis que, même après la fin de la première impulsion de synchronisation (7), le premier état de potentiel peut être établi sur la sortie de libération (3) également par l'autre interrupteur de proximité à ultrasons (2) de même constitution, qui peut être raccordé par l'intermédiaire de la ligne commune (11), lorsque dans cet interrupteur de proximité à ultrasons (2) peut être produite une seconde impulsion de synchronisation (12), qui est en chevauchement avec la première impulsion de synchronisation (7) et est encore présente après que la première impulsion de synchronisation (7) soit passée et qui détermine, par l'intermédiaire de la sortie de libération (3) de l'autre interrupteur de proximité à ultrasons (2), le potentiel de la ligne commune (11) et par conséquent maintient le premier état de potentiel au niveau de la sortie de libération (3) du premier interrupteur de proximité à ultrasons (1), ce qui a pour effet que simultanément l'entrée (5) de l'interrupteur de proximité à ultrasons (1) est maintenue dans l'état qui ne fournit aucune impulsion d'émission, avec comme conséquence le fait qu'une libération des impulsions d'émission dans les interrupteurs de proximité à ultrasons (1,2), qui peuvent être reliés entre eux par l'intermédiaire de la ligne commune (11), ne peut être exécutée que lorsque les deux impulsions de synchronisation (7,12) sont passées et que, par conséquent, la ligne commune (11) est commutée sur le second état de potentiel, ce qui provoque simultanément la commutation de potentiel nécessaire à l'entrée (5) pour la libération de l'impulsion d'émission.

2. Interrupteur de proximité à ultrasons suivant la revendication 1, caractérisé par le fait que le module de commande est réalisé sous la forme d'un microprocesseur (4).

3. Interrupteur de proximité à ultrasons suivant la revendication 1 ou 2, caractérisé par le fait que le circuit (8) est agencé de telle sorte que la sortie de libération (3) est reliée, d'une part, à une première source de tension (14) par l'intermédiaire d'un optocoupleur (16) et, d'autre part, à la masse par l'intermédiaire d'un transistor (15), qui peut être mis à l'état passant par des impulsions de synchronisation (7) et au moyen duquel la sortie de libération (3) peut être commutée du potentiel de la source de tension d'alimentation (14) au potentiel de masse, et que lors de la mise à l'état passant du transistor (15), l'optocoupleur (13) est mis à l'état passant, ce qui a pour effet que l'entrée (5), qui est raccordée au collecteur, est placée au potentiel de la masse au niveau de la borne d'émetteur, et que, lorsque ce coupleur (13) est à l'état bloqué, I'entrée (5) est placée au potentiel d'une seconde source de tension (16) à ce potentiel.

4. Utilisation d'interrupteurs de proximité à ultrasons suivant l'une des revendications précédentes pour un fonctionnement avec une synchronisation en parallèle, caractérisée par le fait que les interrupteurs de proximité sont reliés entre eux par l'intermédiaire de leur sortie de libération (3) au moyen d'une ligne commune 11 (5).

5. Utilisation d'interrupteurs de proximité à ultrasons suivant l'une des revendications précédentes pour un fonctionnement avec une synchronisation en série, caractérisée par le fait que les interrupteurs de proximité à ultrasons sont reliés entre eux par l'intermédiaire de leurs sorties de libération (3), par une ligne commune (11), qu'une adresse, qui caractérise les interrupteurs de proximité à ultrasons, est mémorisée sous la forme d'un créneau temporel (17) respectivement dans le module de commande (4) des interrupteurs de proximité à ultrasons, que sous l'effet du passage des impulsions de synchronisation (7,12), un point de départ commun (18) est positionné pour le déroulement, qui commence conjointement, des différents créneaux temporels (17) à l'intérieur d'une fenêtre temporelle prédéterminée (19), et qu'après la transmission de chaque créneau temporel (17), chaque module de commande (4) envoie au circuit (8) qui est raccordé à ce module, une impulsion de priorité (20), qui est reçue par tous les interrupteurs de proximité reliés entre eux par l'intermédiaire de la ligne (11), la succession des impulsions de priorité (20) étant détectée dans chaque interrupteur de proximité, tandis qu'à la fin du créneau temporel (19), l'interrupteur de proximité délivre tout d'abord son impulsion d'émission (21) et déclenche par conséquent un cycle de mesure, qui a délivré la première impulsion de priorité (20), puis les autres interrupteurs de proximité exécutent successivement leur cycle de mesure conformément à la séquence des impulsions de priorité (20).

6. Utilisation d'interrupteurs de proximité à ultrasons suivant la revendication 4 ou 5, dans laquelle la synchronisation est réalisée par l'intermédiaire d'une unité de commande extérieure, reliée à la ligne (11).
